(19) Europäisches Patentamt
European Patent Office
Office européen des brevets

(11) **EP 2 842 402 B1**

(12) **EUROPÄISCHE PATENTSCHRIFT**

(45) Veröffentlichungstag und Bekanntmachung des Hinweises auf die Patenterteilung:
**05.09.2018 Patentblatt 2018/36**

(21) Anmeldenummer: **13720321.2**

(22) Anmeldetag: **24.04.2013**

(51) Int Cl.:
**H05K 13/08** *(2006.01)*  **H05K 13/00** *(2006.01)*
**G06Q 10/06** *(2012.01)*

(86) Internationale Anmeldenummer:
**PCT/EP2013/058527**

(87) Internationale Veröffentlichungsnummer:
**WO 2014/005744 (09.01.2014 Gazette 2014/02)**

(54) **ZUORDNUNG VON LEITERPLATTEN AUF BESTÜCKUNGSLINIEN**

ALLOCATION OF PRINTED CIRCUIT BOARDS ON FITTING LINES

AFFECTATION DE CARTES DE CIRCUITS IMPRIMÉS SUR DES LIGNES DE MONTAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.07.2012 DE 102012211813**

(43) Veröffentlichungstag der Anmeldung:
**04.03.2015 Patentblatt 2015/10**

(73) Patentinhaber: **Siemens Aktiengesellschaft 80333 München (DE)**

(72) Erfinder:
• **PFAFFINGER, Alexander 81739 München (DE)**
• **ROYER, Christian 85521 Ottobrunn (DE)**
• **HEROLD, Norbert 96123 Litzendorf (DE)**
• **KEMPER, Thorsten 91220 Schnaittach (DE)**
• **CRAIOVAN, Daniel 90491 Nürnberg (DE)**

(56) Entgegenhaltungen:
**EP-A1- 0 478 361**

• **HANS -OTTO GÜNTHER ET AL: "Workload planning in small lot printed circuit board assembly", OR SPECTRUM, Bd. 19, Nr. 2, 1. Juni 1997 (1997-06-01), Seiten 147-157, XP055085604, ISSN: 0171-6468, DOI: 10.1007/BF01545517**
• **DINO LUZZATTO ET AL: "Cell formation in PCB assembly based on production quantitative data", EUROPEAN JOURNAL OF OPERATIONAL RESEARCH, Bd. 69, Nr. 3, 1. September 1993 (1993-09-01), Seiten 312-329, XP055085832, ISSN: 0377-2217, DOI: 10.1016/0377-2217(93)90018-I**
• **Sze Man Ting: "Component Grouping for Circuit Board Assembly", , 1. Januar 1999 (1999-01-01), XP055085614, Gefunden im Internet: URL:http://repository.lib.polyu.edu.hk/jspui/bitstream/10397/3911/2/b14846755_ir.pdf [gefunden am 2013-10-28]**

**Beschreibung**

Die vorliegende Erfindung betrifft ein Verfahren zur Zuordnung von Leiterplatten auf Bestückungslinien zur Bestückung der Leiterplatten mit Bauelementen. Weiterhin betrifft die Erfindung eine Steuereinrichtung für eine Fertigungs- oder Montagelinie zur Bestückung von Leiterplatten oder anderen Baugruppen mit Bauelementen. Außerdem betrifft die Erfindung ein Computerprogrammprodukt und ein computerlesbares Medium.

Insbesondere im Bereich der Elektronikproduktion werden zu fertigende Leiterplatten bzw. Baugruppen auf SMT-Bestückungslinien durch Oberflächenmontage (surface mounted technology, SMT) hergestellt. Auf Grund von technischen Restriktionen kann aber nicht jede Leiterplatte auf jeder Bestücklinie gefertigt werden. Die Leiterplatten besitzen auf den Bestückungslinien meist auch unterschiedliche Produktionszeiten. Zudem dürfen die maximalen Produktionszeitkapazitäten der Bestückungslinien nicht überschritten werden.

DE 10 2009 013 353 B3 zeigt ein Verfahren zur Rüstung einer solchen Bestückungslinie.

Hans-Otto Günther et al. "Workload planning in small lot printed circuit board assembly", OR Spectrum, Bd. 19, Nr. 2, 1. Juni 1997, S. 147-157 betrifft die Planung einer Arbeitsauslastung bei der automatisierten Bestückung von Leiterplatten.

Dino Luzzatto et al.: "Cell formation in PCB assembly based on production quantitative data", European Journal of Operational Research, Bd. 69, Nr. 3, 1. September 1993, S. 312-329 betrifft ein Verfahren zur Planung einer Bestückung von Leiterplatten.

EP 0 478 361 A1 betrifft ein Verfahren zur Bestückung von Leiterplatten mit Bauelementen, wobei eine Produktionshäufigkeit eines Leiterplattentyps und die zur Produktion erforderlichen Bauelemente berücksichtigt werden.

Sze Man Ting: "Component Grouping for Circuit Board Assembly", 1. Januar 1999, betrifft das Gruppieren von Bauteilen bei der automatisierten Bestückung von Leiterplatten.

Die Zuordnung von Leiterplatten auf Bestücklinien eines Bestückungssystems erfolgt üblicherweise manuell oder halbautomatisch, basierend auf Erfahrungswerten oder Heuristiken. Dabei hat es sich in der Praxis gezeigt, dass immer wieder unausgewogene Zuordnungen getroffen werden, die eine hohe Auslastung einer Komponente einer Bestückungslinie mit einer niedrigen Auslastung einer anderen Komponente bedingen, so dass das Bestückungssystem nicht optimal genutzt werden kann.

Es ist Aufgabe der vorliegenden Erfindung, eine verbesserte Technik zur Zuordnung von Leiterplatten auf Bestückungslinien bereitzustellen.

Die Erfindung löst diese Aufgabe mittels eines Verfahrens und einer Steuereinrichtung mit den Merkmalen der unabhängigen Ansprüche. Unteransprüche geben bevorzugte Ausführungsformen wieder.

Ein Bestückungssystem umfasst mehrere Bestückungslinien zur Bestückung von Leiterplatten mit elektronischen Bauteilen. Ein Verfahren zur Zuordnung von Leiterplatten an die Bestückungslinien umfasst Schritte des Erfassens von Anforderungen zur Bestückung mehrerer Leiterplatten mit jeweils auf ihnen zu bestückenden Bauteilen und des Zuordnens der Leiterplatten an Bestückungslinien unter vorbestimmten Vorgaben mittels ganzzahliger Linearer Programmierung. Dabei erfolgt das Zuordnen derart, dass Bauteilevarianzen der Bestückungslinien möglichst gleich sind, wobei die Bauteilevarianz einer Bestückungslinie die Anzahl unterschiedlicher Bauteile repräsentiert, die auf allen der Bestückungslinie zugeordneten Leiterplatten zu bestücken sind. Anders ausgedrückt ist einer der Parameter der ganzzahligen Linearen Programmierung so gewählt, dass bei der Zuordnung eine Optimierung bezüglich der Gleichverteilung der Bauteilevarianzen der Bestückungslinien erfolgt.

Dabei ist eine Rüstfamilie bestimmt als eine Menge von Leiterplatten, die auf einer Bestückungslinie bestückt werden können, ohne die Menge der Bauteiltypen zu ändern, die an der Bestückungslinie für die Bestückung bereit gehalten sind. Die Menge der an der Bestückungslinie bereit gehaltenen Bauteiltypen wird auch Rüstung genannt.

Üblicherweise sind einer Bestückungslinie mehr Leiterplatten zugeordnet als von einer Rüstfamilie umfasst sein können, da an der Bestückungslinie nicht beliebig viele Bauteiltypen bereit gehalten werden können. Die Bestückungslinie wird daher gelegentlich einem Rüstwechsel unterzogen, bei dem die Rüstung für eine erste Rüstfamilie gegen die Rüstung für eine zweite Rüstfamilie gewechselt wird. Je seltener diese Rüstwechsel sind und je weniger Bauteiltypen bei einem Rüstwechsel gewechselt werden müssen, desto kostengünstiger kann das Bestückungssystem betrieben werden.

Durch die angestrebte Gleichverteilung der Bauteilevarianzen kann erreicht werden, dass Umrüstungen einer Bestückungslinie weniger häufig erforderlich ist. Ferner können Anzahlen von Rüstfamilien auf den einzelnen Bestückungslinien weniger unterschiedlich voneinander sein.

Variable Elemente der Bestückungslinie, beispielsweise ein Wechseltisch oder ein Förderer, können so insgesamt weniger häufig umzurüsten sein. Dabei ist ein Wechseltisch ein Zuführtisch, der eine vorbestimmte Anzahl unterschiedlicher elektronischer Bauteile zur Bestückung bereithält. Muss ein Wechseltisch während einer Umrüstung einer Bestückungslinie getauscht werden, so spricht man von einem variablen Tisch, andernfalls von einem konstanten Tisch. Das Verfahren kann dazu beitragen, vermehrt konstante Tische zu bilden. Dabei können Rüstfamilien gleichmäßiger über die Bestückungslinien verteilt werden. Ebenso kann vermieden werden, dass für das Bestückungssystem eine große Anzahl Rüstfamilien gebildet werden muss, was zu erhöhter Komplexität und gegebenenfalls komplexeren Umrüstungen des Bestückungssystems führen kann. Die Praxis zeigt, dass ein Zusammenhang zwischen der Bauelementevarianz einer vorbestimmten Anzahl Leiterplatten und einer Anzahl Rüstfamilien nicht linear sondern eher exponentiell ist.

Die ganzzahliger lineare Programmierung kann mittels eines Standard-Solvers durchgeführt werden, der als kommerzielles Produkt erhältlich ist. Dabei können in dem Solver Randbedingungen bzw. Optimierungsziele angegeben werden, um dafür zu sorgen, dass die Bauteilevarianzen der Bestückungslinien möglichst gleich sind.

In einer Ausführungsform kann festgelegt werden, dass das Zuordnen derart erfolgt, dass die Bauteilevarianz jeder Bestückungslinie unterhalb einer vorbestimmten Schwelle liegt.

Übermäßige Bauteilevarianzen auf einer Bestückungslinie können so verhindert werden.

Alternativ oder zusätzlich kann das Zuordnen derart erfolgen, dass die Bauteilevarianz jeder Bestückungslinie oberhalb einer vorbestimmten Schwelle liegt. Dadurch kann verhindert werden, dass eine der Bestückungslinien eine zu geringe Bauteilevarianz aufweist, was zu einer überproportional größeren Bauteilevarianz auf wenigstens einer der anderen Bestückungslinien führen könnte.

Ferner kann das Zuordnen derart erfolgen, dass die maximale Bauteilevarianz aller Bestückungslinien möglichst minimiert ist. Auch dadurch kann die Gleichverteilung der Bauteilevarianzen über die Bestückungslinien verbessert werden.

Darüber hinaus kann das Zuordnen auch derart erfolgen, dass der maximale Spurverbrauch aller Bestückungslinien möglichst minimiert ist. Dadurch können die Anzahlen von Rüstfamilien für die Bestückungslinien verbessert gleich gehalten werden. In einer weiteren Ausführungsform erfolgt das Zuordnen derart, dass die Summe der Bauteilevarianzen aller Bestückungslinien möglichst minimiert ist. Insbesondere in Verbindung mit der Optimierung der beschriebenen Gleichverteilung von Bauteilevarianzen auf Bestückungslinien können so weiter verbesserte Ergebnisse erzielbar sein.

Außerdem kann das Zuordnen derart erfolgen, dass die Summe der Spurverbräuche aller Bauteile einer Bestückungslinie unterhalb einer vorbestimmten Schwelle liegt. Ein Bestückungsautomat einer Bestückungslinie hat üblicherweise eine vorbestimmte Spurbreite, welche die Anzahl gleich breiter Spuren angibt, die zur Förderung von Bauteilen verwendet werden können. Dabei kann ein Bauteil auch mehrere Spuren erfordern.

Weiter kann das Zuordnen derart erfolgen, dass die Summe der Spurverbräuche aller Bauteile einer Bestückungslinie oberhalb einer vorbestimmten Schwelle liegt. Durch die Angabe einer unteren Schranke für die Summe der Spurverbräuche einer Bestückungslinie kann vermieden werden, dass eine große Anzahl Spuren ungenutzt bleibt.

In einer weiteren Ausführungsform erfolgt das Zuordnen derart, dass die Summe der Spurverbräuche aller Bauteile einer Bestückungslinie möglichst minimiert ist. Auch diese Maßnahme kann dazu beitragen, einen häufigen Wechsel von variablen Wechseltischen und das Vorhalten einer großen Anzahl Wechseltische zu vermeiden.

In noch einer weiteren Ausführungsform erfolgt das Zuordnen derart, dass ein Kriterium möglichst optimiert wird, das mehrere gewichtete Einzelkriterien umfasst. Ein Kriterium kann dabei die beschriebene Gleichverteilung der Bauteilevarianzen, ein anderes beispielsweise die Summe der Bauteilevarianzen aller Bestückungslinien betreffen. Durch die Gewichtung kann eine Präferenz für einen der Parameter beispielsweise in Abhängigkeit von lokalen oder aktuellen Dringlichkeiten steuerbar sein.

Ein Computerprogrammprodukt umfasst Programmcodemittel zur Durchführung des beschriebenen Verfahrens, wenn es auf einer Ausführungseinrichtung abläuft oder auf einem computerlesbaren Medium gespeichert ist. Das Computerprogrammprodukt kann in einer üblichen Programmiersprache (z.B. C++, Java) erstellt sein. Die Verarbeitungseinrichtung kann einen marktüblichen Computer oder Server mit entsprechenden Eingabe-, Ausgabe- und Speichermitteln umfassen.

Eine Steuereinrichtung für ein Bestückungssystem mit mehreren Bestückungslinien zur Bestückung von Leiterplatten mit elektronischen Bauteilen ist dazu eingerichtet, Anforderungen zur Bestückung mehrerer Leiterplatten mit jeweils auf ihnen zu bestückenden Bauteilen zu erfassen und die Leiterplatten unter gegebenen Vorgaben mittels ganzzahliger linearer Programmierung derart an Bestückungslinien zuzuordnen, dass Bauteilevarianzen der Bestückungslinien möglichst gleich sind, wobei die Bauteilevarianz einer Bestückungslinie die Anzahl unterschiedlicher Bauteile repräsentiert, die auf allen der Bestückungslinie zugeordneten Leiterplatten zu bestücken sind.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:

Fig. 1    ein Bestückungssystem;

Fig. 2    ein Ablaufdiagramm eines Verfahrens; und

Fig. 3    ein Ablaufdiagramm eines Optimierungsverfahrens mittels ganzzahliger Linearer Programmierung

darstellt.

Die Lineare Optimierung ist eines der Hauptverfahren auf dem Gebiet mathematische Optimierung und befasst sich mit der Optimierung linearer Zielfunktionen über einer Menge, die durch lineare Gleichungen und Ungleichungen eingeschränkt ist. Die Lineare Optimierung ist die Grundlage der Lösungsverfahren der (gemischt) ganzzahligen Linearen Optimierung.

Vorteile der Linearen Optimierung:

- Globaler Optimierungsansatz.
- Leicht erweiterbar.
- Sehr gute kommerzielle Standard-Solver (SCIP, CPLEX, Ilog, Xpress), die in der Praxis weit verbreitet und bewährt sind.
- Für eine ermittelte Lösung ist bekannt, wie weit sie maximal von der optimalen Lösung entfernt ist (Gap).

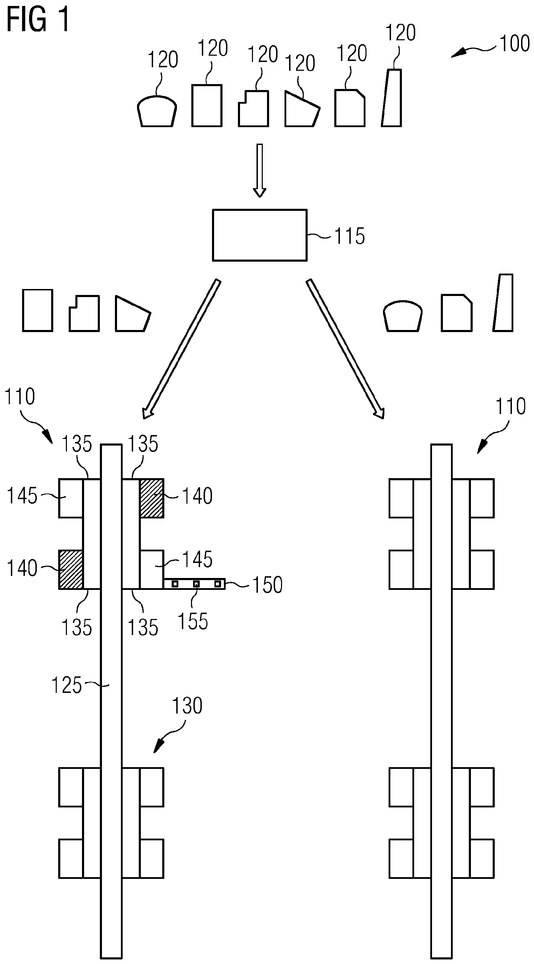

Figur 1 zeigt ein Bestückungssystem 100. Das Bestückungssystem 100 umfasst mehrere Bestückungslinien 110 und eine Steuereinrichtung 115 zur Zuordnung von Leiterplatten 120 an die Bestückungslinien 110. Jede Bestückungslinie 110 umfasst üblicherweise ein Transportsystem 125 und ein oder mehrere Bestückungsautomaten 130. Jeder Bestückungsautomat 130 umfasst einen oder mehrere Bestückungsköpfe 135, die jeweils dazu eingerichtet sind, von einem konstanten Tisch 140 oder einem variablen Tisch 145 Bauelemente aufzunehmen und an einer vorbestimmten Position auf der Leiterplatte 120 zu positionieren, die sich auf dem Transportsystem 125 befindet.

Während des Bestückungsvorgangs besteht die Leiterplatte 120 bezüglich des Bestückungsautomaten 130 üblicherweise still. Die Tische 140, 145 umfassen jeweils eine Vielzahl Zuführungseinrichtungen 150, von denen nur eine exemplarisch dargestellt ist. Jede Zuführungseinrichtung 150 hält einen Vorrat von Bauteilen 155 eines vorbestimmten Typs bereit. Zwar kann jede Zuführungseinrichtung 150 zur Bereithaltung unterschiedlicher Bauteile 155 konfiguriert werden und unterschiedliche Zuführungseinrichtungen 150 an einem Tisch 140, 145 angebracht werden, jedoch werden die Tische 140, 145 aus Geschwindigkeitsgründen üblicherweise komplett ausgetauscht, wenn ein Bestückungsautomat 130 mit Bauteilen 155 versorgt werden muss, die nicht auf einem der angebrachten Tische 140, 145 vorgehalten sind. Da ein solcher Wechsel üblicherweise mit einem Produktionsstillstand verbunden ist, wird angestrebt, die Zahl der zu wechselnden Tische 140, 145 gering zu halten. Wird ein Tisch während eines Umrüstvorgangs nicht ausgetauscht, so wird er als konstanter Tisch 140 bezeichnet, ansonsten als variabler Tisch 145. Funktionale Unterschiede zwischen einem konstanten Tisch 140 und einem variablen Tisch 145 bestehen ansonsten nicht.

Die Leiterplatte 120 ist mit einer Anzahl unterschiedlicher Bauteile 155 zu bestücken. Um ein häufiges Wechseln von variablen Tischen 145 zu minimieren und idealerweise eine Zahl konstanter Tische 140 zu maximieren, ist die Steuereinrichtung 115 dazu eingerichtet, die Zuordnung einer Leiterplatte 120 an eine der Bestückungslinien 110 zu optimieren. Dabei müssen üblicherweise spezifische Eigenschaften jeder Bestückungslinie 110 bzw. jedes Bestückungsautomaten 130 genauso berücksichtigt werden, wie Eigenschaften der Leiterplatten 120 bzw. der auf ihnen zu bestückenden Bauteile 155.

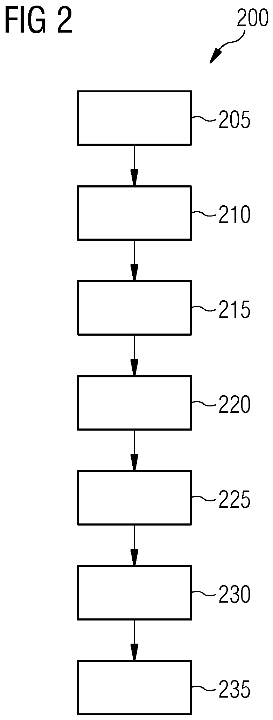

Figur 2 zeigt ein Ablaufdiagramm eines Verfahrens 200 zur Zuordnung von Leiterplatten 120 an Bestückungslinien 110 des Bestückungssystems 100 aus Figur 1.

Schritt 205: Im ersten Schritt 205 werden Anforderungen zur Zuordnung von Leiterplatten 120 erfasst. Eine Anforderung definiert eine Leiterplatte 120 und die auf ihr zu bestückenden Bauteile 155. Zusätzlich kann eine Anzahl von Randbedingungen angegeben sein, beispielsweise welche Leiterplatte 110 auf welcher Bestückungslinie 110 bestückt werden kann oder welches Bauelement 155 durch die Bestückungslinie 110 verarbeitbar ist. Weitere Randbedingungen finden sich unten bei der Diskussion des mathematischen Hintergrunds.

Anschließend werden in Schritten 210 bis 230 Kriterien bzw. Randbedingungen definiert, welche eine spätere Zuordnung einer Leiterplatte 120 zu einer Bestückungslinie 110 beeinflussen. Dabei ist jeder der dargestellten Schritte 210 bis 230 optional, so dass einzelne oder alle Schritte 210 bis 230 auch entfallen können.

Schritt 210: Es wird für wenigstens eine der Bestückungslinien 110 eine maximale Bauteilevarianz festgelegt. Dabei kann eine individuelle Festlegung getroffen werden, so dass unterschiedliche Bestückungslinien 100 potentiell unterschiedliche maximale Bauteilevarianzen aufweisen können. Die maximale Bauteilevarianz kann von einer Eigenschaft oder einem Parameter der jeweiligen Bestückungslinie 110 abhängig sein.

Schritt 215: Hier wird in entsprechender Weise für wenigstens eine der Bestückungslinien 110 eine minimale Bauteilevarianz festgelegt. Auch dieser Parameter kann für jede der Bestückungslinien 110 individuell bestimmt werden, beispielsweise auf der Basis von einer Eigenschaft oder eines Parameters der jeweiligen Bestückungslinie 110.

Schritt 220: Es wird ein zu optimierendes Kriterium für die nachfolgende Zuordnung von Leiterplatten 120 zu Bestückungslinien 110 bestimmt. Die Zuordnung wird später so durchgeführt, dass das Kriterium möglichst optimiert wird, also je nach Kontext möglichst minimiert oder möglichst maximiert.

In einer Ausführungsform besteht das Kriterium in einem Maß für die Ausgeglichenheit der Bauteilevarianzen zwischen den einzelnen Bestückungslinien 110. Dabei kann ein numerisch großes Kriterium auf eine geringe Ausgeglichenheit und ein numerisch kleines Kriterium auf eine hohe Ausgeglichenheit der Bauteilevarianzen der Bestückungslinien 110 hinweisen. In diesem Fall wird das Kriterium bei der späteren Zuordnung möglichst minimiert. Beispielsweise kann das Kriterium auf eine Standardabweichung der Bauteilevarianzen der Bestückungslinien 110 zurückgehen.

In einer anderen Ausführungsform betrifft das Kriterium die Bauteilevarianz aller Bestückungslinien 110 und ist als Summe der Bauteilevarianzen aller Bestückungslinien 110 bestimmt. In diesem Fall ist das Kriterium für eine Optimierung möglichst zu minimieren.

In noch einer weiteren Ausführungsform betrifft das Kriterium das Maximum der Bauteilevarianzen aller Bestückungslinien 110. Auch hier wird möglichst eine Minimierung des Kriteriums angestrebt.

In noch einer weiteren Ausführungsform betrifft das Kriterium das Maximum der Spurverbräuche auf allen Bestückungslinien 110; dieses Kriterium ist ebenfalls zu minimieren.

In noch einer Ausführungsform ist das Kriterium zusammengesetzt aus gewichteten Einzelkriterien wie den oben genannten Kriterien der Ausgeglichenheit von Bauteilevarianzen der Bestückungslinien 110, der Summe der Bauteilevarianzen aller Bestückungslinien 110 und dem Maximum der Bauteilevarianzen aller Bestückungslinien 110. Gewichtungsfaktoren der Einzelkriterien zur Bildung des Kriteriums können frei wählbar sein. In einer Variante kann einer der Gewichtungsfaktoren auch von einem anderen Parameter des Bestückungssystems 100 abhängig sein, beispielsweise einem Auslastungsgrad.

Bevorzugterweise ist das Kriterium aus gewichteten Einzelkriterien zusammengesetzt, welche die Summe der Bauteilevarianzen aller Bestückungslinien 110 und die Ausgeglichenheit der Bauteilevarianzen der Bestückungslinien 110 betreffen.

In einer Ausführungsform kann ein weiteres gewichtetes Einzelkriterium verwendet werden, das eine Ausgeglichenheit von Spurverbräuchen auf den Bestückungslinien 110 betrifft. Ein Tisch 140 oder 145 oder eine Zuführungseinrichtung 150 weist zur Aufnahme von Bauteilen 155 üblicherweise eine Anzahl Spuren auf, die jeweils gleich breit sind, beispielsweise 8 mm. Während ein kleines Bauteil 155 wie ein Widerstand oder ein Kondensator nur eine Spur verbrauchen kann, kann ein größeres Bauteil wie eine integrierte Schaltung, ein Abschirmblech oder ein Gehäuseelement, mehrere aneinander angrenzende Spuren erfordern. Ein Spurverbrauch des kleinen Bauteils 155 wäre in diesem Beispiel 1, die des großen Bauteils größer, beispielsweise 4.

Um die Spurverbräuche der Bestückungslinien 110 einander möglichst anzugleichen, kann die Summe der Spurverbräuche aller Bestückungslinien 110 minimiert werden, wobei der Spurverbrauch einer Bestückungslinie 110 die Summe der Spurverbräuche aller Bauteile 155 umfasst, die auf eine der Leiterplatten 120 bestückt werden sollen, die der jeweiligen Bestückungslinie 110 zugeordnet sind.

Schritt 225: Als unterstützende Maßnahme zur Angleichung der Spurverbräuche der Bestückungslinien 110 kann für wenigstens eine der Bestückungslinien 110 eine maximale Summe für Spurverbräuche gesetzt werden.

Schritt 230: In ähnlicher Weise kann für wenigstens eine der Bestückungslinien 110 eine minimale Summe von Spurverbräuchen gesetzt werden.

Schließlich erfolgt im Schritt 235 eine Zuordnung von Leiterplatten 120 zu Bestückungslinien 110. Das Zuordnen im Schritt 235 unter den gegebenen Vorgaben erfolgt bevorzugterweise mittels ganzzahliger linearer Programmierung.

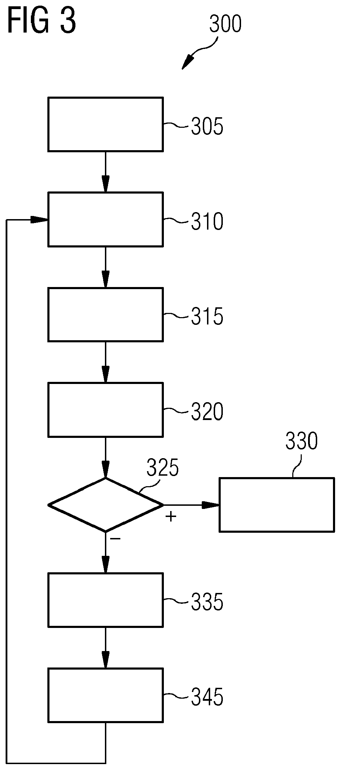

Ein einbettendes Verfahren 300 ist in Form eines Ablaufdiagramms in Figur 3 dargestellt.

Schritt 305: Zunächst wird eine Startzuordnung von Leiterplatten 120 auf Bestückungslinien 110 bestimmt und eine aktuelle Zuordnung wird der Startzuordnung gleichgesetzt. Für die Ermittlung der Startzuordnung sind unterschiedliche Heuristiken möglich, die auch manuelle Vorgaben oder Restriktionen umfassen können.

Schritt 310: Anschließend wird eine Teilmenge von Leiterplatten 120 aus den zuzuordnenden Leiterplatten 120 ausgewählt.

Schritt 315: Danach werden eine oder mehrere alternative Zuordnungen von Leiterplatten 120 der Teilmenge an die Bestückungslinien 110 gebildet, vorzugsweise mittels ganzzahliger linearer Programmierung. Diese Zuordnungen erfolgen auf die mit Bezug auf Figur 3 beschriebene Weise derart, dass die Bauteilevarianzen der einzelnen Bestückungslinien 110 möglichst ausgeglichen sind. Es kann auch ein gewichtetes Kriterium mehrerer Einzelkriterien für die Zuordnung verwendet werden, so dass auch noch weitere Parameter möglichst minimiert oder möglichst maximiert werden können, um eine optimierte Zuordnung zu erzielen.

Schritt 320: Hier werden die Qualitäten der in Schritt 315 gebildeten Zuordnungen bestimmt bzw. aus den Parametern der linearen Optimierung von Schritt 315 übernommen. Dabei sind üblicherweise einer oder mehrere Qualitätsparameter vorgegeben, die beispielsweise einen Auslastungsgrad eines Bestückungsautomaten 130 oder das Verhältnis von konstanten Tischen 140 zu variablen Tischen 145 umfassen können. Im Zusammenhang mit dem Verfahren von Figur 2 wird vorzugsweise als Qualitätsparameter ein Kriterium verwendet, das mehrere gewichtete Einzelkriterien umfasst, von denen eines die Ausgeglichenheit der Bauelementevarianzen aller Bestückungslinien 110 möglichst maximiert.

Schritt 325: Danach wird überprüft, ob ein vorbestimmtes Abbruchkriterium erreicht ist. Das Abbruchkriterium kann eine Zuordnung einer vorbestimmten Qualität oder das Ablaufen einer vorbestimmten Rechenzeit für das Verfahren 300 umfassen.

Schritt 330: Die bestimmten Zuordnungen werden ausgegeben, falls das Abbruchkriterium erfüllt ist.

Schritt 335: Andernfalls können unter den bestimmten Zuordnungen solche ausgewählt werden, die weiter optimiert werden sollen.

Schritt 340: In diesem Fall wird die aktuelle Zuordnung auf eine der zu optimierenden Zuordnungen gesetzt und das Verfahren 300 kann ab dem Schritt 310 erneut durchlaufen. Wurden mehrere optimierbare Zuordnungen ausgewählt, so kann das Verfahren 300 auch entsprechend mehrfach parallel verzweigt werden.

Mathematischer Hintergrund

Durch den Einsatz von exakten mathematischen Verfahren lassen sich deutlich bessere Lösungen erzielen als mit bisher in der Praxis verwendeten Heuristiken. Im weiteren Unterschied dazu können mit diesen Verfahren auch gute Produktionszeiten erreicht werden.

Bei der Zuordnung von Leiterplatten 120 bzw. Baugruppen an eine Bestückungslinie 110 ist zu beachten, dass auf Grund von technischen Restriktionen möglicherweise nicht jede Leiterplatte 120 auf jeder Bestückungslinie 110 gefertigt werden kann. Die Leiterplatten besitzen auf den Bestückungslinien 110 meist auch unterschiedliche Produktionszeiten. Zudem dürfen die maximalen Produktionszeitkapazitäten der Bestückungslinien 110 nicht überschritten werden.

Bei der Zuordnung von Leiterplatten 120 auf Bestückungslinien 110 werden üblicherweise folgende Ziele verfolgt:

- es sollen möglichst viele Leiterplatten 120 mit konstanten Tischen 140 gefertigt werden können, um den Umrüstaufwand zu reduzieren;
- die Anzahl der Rüstfamilien ("Cluster") an den Bestückungslinien 110 soll möglichst gering sein, um den zeitlichen Umrüstaufwand zu reduzieren;
- man möchte möglichst wenig Rüstequipment (z.B. Förderer 150) benötigen;
- die Anzahl der insgesamt benötigten Tische auf den Festrüstungslinien sollte möglichst gering sein;
- die Anzahl der konstanten Tische auf den Festrüstungslinien sollte möglichst hoch sein, und
- die Gesamtproduktionszeit für die Leiterplatten 120 sollte möglichst minimal sein.

Diese Ziele versucht man gewöhnlich zu erreichen, indem eine möglichst hohe Bauteilüberdeckung der Leiterplatten 120 einer Bestückungslinie 110 angestrebt wird, bzw. die Summe der Bauelementvarianzen der Bestückungslinien 110 minimiert wird.

Zur Bestimmung einer optimierten Zuordnung von Leiterplatten 120 an Bestückungslinien 110 werden IP-Modelle (IP steht für Integer Programmierung bzw. für Integer Programm oder ganzzahliges Optimierungsmodell) verwendet. Diese Bestimmung kann mittels eines bekannten Standard-Solvers durchgeführt werden.

**Indices**

| | |
|---|---|
| L | Menge der SMT-Bestücklinien 110 des Systems 100 |
| R | Menge der Leiterplatten 120 |
| C | Menge der Bauelementtypen 155 |
| $R_c$ | Menge der Leiterplatten mit Bauelementtyp c |
| $R_l$ | Menge der bestückbaren Leiterplatten auf Linie $l$ |

**Parameter**

| | |
|---|---|
| $Time_{r,l}$ | Gesamtproduktionszeit für Leiterplatte r auf Linie $l$ |
| $TimeLimit_l$ | Produktionszeitschranke auf Linie $l$ |

**Binär-Variablen**

| | |
|---|---|
| $Assign_{r,l}$ | Zuordnung Leiterplatte r zu Linie $l$ |

$Setup_{c,l}$   Verwendung eines Bauelements c auf einer Linie *l*

**IP Formulierung**

$$\text{minimize} \sum_{c \in C} \sum_{l \in L} Setup_{c,l}$$

s.t.:

$$\sum_{l \in L} Assign_{r,l} = 1 \qquad\qquad r \in R$$

$$Assign_{r,l} = 0 \qquad\qquad l \in L, r \in R / R_l$$

$$\sum_{r \in R_c} Assign_{r,l} \leq Setup_{c,l} |R_c| \qquad\qquad c \in C, l \in L$$

$$\sum_{r \in R} Assign_{r,l} Time_{r,l} \leq TimeLimit_l \qquad\qquad l \in L$$

$$Setup_{c,l} \in \{0,1\} \qquad\qquad c \in C, l \in L$$

$$Assign_{r,l} \in \{0,1\} \qquad\qquad r \in R, l \in L$$

Zur Verbesserung der Zuordnung von komplexen Leiterplatten 120 über die Bestückungslinien 110 können dem Solver Bedingungen zur Verfügung gestellt werden. Die gestellten Bedingungen zielen - wenigstens auch - darauf ab, eine Optimierung der Zuordnung von Leiterplatten 120 auf die Bestückungslinien 110 derart durchzuführen, dass die Bauelementevarianzen der Bestückungslinien 110 möglichst gleich über die Bestückungslinien 110 verteilt sind.
Eine erste Bedingung kann darin bestehen, die Bauelementvarianz pro Bestückungslinie *l* nach oben durch eine vorbestimmte Schranke zu beschränken.

$$\forall l \in L : \sum_{c \in C} Setup_{c,l} \leq MaxSetup_l$$

$MaxSetup_l$ : erste vorbestimmte Anzahl
Ferner kann die Bauelementvarianz pro Bestückungslinie *l* auf eine minimale Anzahl $MinCountBig_l$ nach unten beschränkt werden.

$$\forall l \in L : \sum_{c \in C} Setup_{c,l} \geq MinSetup_l$$

$MinSetup_l$ : zweite vorbestimmte Anzahl

Die maximale Bauelementvarianz aller Bestückungslinien kann als zusätzliche gewichtete Zielfunktionskomponente definiert werden, die zu optimieren ist.

$$\min \max_{l \in L} \sum_{c \in C} Setup_{c,l}$$

Die Summe der Spurverbräuche aller Bauteile einer Bestückungslinie *l* kann nach oben auf *MaxCapacity$_l$* beschränkt werden.

$$\forall l \in L : \sum_{c \in C} Setup_{c,l} Width_c \leq MaxCapacity_l$$

*MaxCapacity$_l$* : dritte vorbestimmte Anzahl

Die Summe der Spurverbräuche aller Bauteile 155 einer Bestückungslinie *l* kann nach unten auf *MinCapUtilisation$_l$* beschränkt werden. Dabei bezeichnet *Width$_c$* den Spurverbrauch eines Bauelements 155.

$$\forall l \in L : \sum_{c \in C} Setup_{c,l} Width_c \geq MinCapUtilisation_l$$

*MinCapUtilisation$_l$* : vierte vorbestimmte Anzahl

Schließlich kann die Summe der Spurverbräuche aller Bauteile 155 einer Bestückungslinie *l* über alle Bestückungslinien 110 als zusätzliche gewichtete Zielfunktionskomponente angegeben werden.

$$\min \max_{l \in L} \sum_{c \in C} Setup_{c,l} Width_c$$

Durch Anwendung wenigstens einer dieser Vorgaben kann eine verbesserte Verteilung der Leiterplatten 120 über die Bestückungslinen 110 bewirkt werden, so dass Umrüstungen von Bestückungslinien 110 verringert werden können. Außerdem können Produktionszeiten von Leiterplatten 120 im Bestückungssystem 100 verbessert werden. Ferner können die Zuordnungen mit dem beschriebenen Ansatz mittels eines IP-Solvers rascher als bislang bekannt bestimmbar sein.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren (200) zur Bestückung von Leiterplatten (120) mittels Bestückungslinien (110) eines Bestückungssystems (100) zur Bestückung der Leiterplatten (120) mit elektronischen Bauteilen (155), wobei das Verfahren (200) folgende Schritte umfasst:

   - Erfassen (205) von Anforderungen zur Bestückung mehrerer Leiterplatten (120) mit jeweils auf ihnen zu bestückenden Bauteilen (155),
   - wobei eine Anforderung eine Leiterplatte (120) und die auf ihr zu bestückenden Bauteile (155) definiert, und
   - Zuordnen (235) der Leiterplatten (120) an Bestückungslinien (110) unter vorbestimmten Vorgaben mittels ganzzahliger Linearer Programmierung und
   - Bestücken der Leiterplatten (120) auf den jeweils zugeordneten Bestückungslinien (110),

   **dadurch gekennzeichnet, dass**

- das Zuordnen (235) derart erfolgt, dass Bauteilevarianzen der Bestückungslinien (110) möglichst gleich sind,
- wobei die Bauteilevarianz einer Bestückungslinie (110) die Anzahl unterschiedlicher Bauteile (155) repräsentiert, die auf allen der Bestückungslinie (110) zugeordneten Leiterplatten (120) zu bestücken sind.

2. Verfahren (200) nach Anspruch 1, wobei das Zuordnen (235) derart erfolgt, dass die Bauteilvarianz jeder Bestückungslinie (110) unterhalb einer vorbestimmten Schwelle liegt (210).

3. Verfahren (200) nach Anspruch 1 oder 2, wobei das Zuordnen (235) derart erfolgt, dass die Bauteilvarianz jeder Bestückungslinie (110) oberhalb einer vorbestimmten Schwelle liegt (215).

4. Verfahren (200) nach einem der vorangehenden Ansprüche, wobei das Zuordnen (235) derart erfolgt, dass die maximale Bauteilvarianz aller Bestückungslinien (110) möglichst minimiert ist (220).

5. Verfahren (200) nach einem der vorangehenden Ansprüche, wobei das Zuordnen (235) derart erfolgt, dass der maximalen Spurverbrauch aller Bestückungslinien (110) möglichst minimiert ist (220).

6. Verfahren (200) nach einem der vorangehenden Ansprüche, wobei das Zuordnen (235) derart erfolgt, dass die Summe der Bauteilevarianzen aller Bestückungslinien (110) möglichst minimiert ist (220).

7. Verfahren (200) nach einem der vorangehenden Ansprüche, wobei das Zuordnen (235) derart erfolgt, dass die Summe der Spurverbräuche aller Bauteile (155) einer Bestückungslinie (110) unterhalb einer vorbestimmten Schwelle liegt (225) .

8. Verfahren (200) nach einem der vorangehenden Ansprüche, wobei das Zuordnen (235) derart erfolgt, dass die Summe der Spurverbräuche aller Bauteile einer Bestückungslinie (110) oberhalb einer vorbestimmten Schwelle liegt (230).

9. Verfahren (200) nach einem der vorangehenden Ansprüche, wobei das Zuordnen (235) derart erfolgt, dass die Summe der Spurverbräuche aller Bauteile (155) einer Bestückungslinie (110) möglichst minimiert ist (220).

10. Verfahren (200) nach einem der vorangehenden Ansprüche, wobei das Zuordnen (235) derart erfolgt, dass ein Kriterium möglichst optimiert wird, das mehrere gewichtete Einzelkriterien umfasst.

11. Steuereinrichtung (115) zur Zuordnung von Leiterplatten (120) an Bestückungslinien (110) eines Bestückungssystems (100), wobei die Steuereinrichtung (115) dazu eingerichtet ist:

    - Anforderungen zur Bestückung mehrerer Leiterplatten (120) mit jeweils auf ihnen zu bestückenden Bauteilen (155) zu erfassen;
    - wobei eine Anforderung eine Leiterplatte (120) und die auf ihr zu bestückenden Bauteile (155) definiert;
    - die Leiterplatten (120) unter vorbestimmten Vorgaben mittels ganzzahliger Linearer Programmierung derart an Bestückungslinien zuzuordnen (235), dass Bauteilevarianzen der Bestückungslinien (110) möglichst gleich sind,
    - wobei die Bauteilevarianz einer Bestückungslinie (110) die Anzahl unterschiedlicher Bauteile (155) repräsentiert, die auf allen der Bestückungslinie (110) zugeordneten Leiterplatten (120) zu bestücken sind.

## Claims

1. Method (200) for fitting printed circuit boards (120) with components using fitting lines (110) of a fitting system (100) for fitting the printed circuit boards (120) with electronic components (155), the method (200) comprising the following steps:

    - detecting (205) requirements for fitting a plurality of printed circuit boards (120) with components (155) to be respectively fitted thereon,
    - a requirement defining a printed circuit board (120) and the components (155) to be fitted thereon, and
    - allocating (235) the printed circuit boards (120) to fitting lines (110) under predetermined specifications by means of integer linear programming, and
    - fitting the printed circuit boards (120) with components on the respectively allocated fitting lines (110),

**characterized in that**

- the allocation (235) is carried out in such a manner that component variances of the fitting lines (110) are as similar as possible,
- the component variance of a fitting line (110) representing the number of different components (155) which can be fitted on all printed circuit boards (120) allocated to the fitting line (110).

2. Method (200) according to Claim 1, the allocation (235) being carried out in such a manner that the component variance of each fitting line (110) is below a predetermined threshold (210) .

3. Method (200) according to claim 1 or 2, the allocation (235) being carried out in such a manner that the component variance of each fitting line (110) is above a predetermined threshold (215).

4. Method (200) according to one of the preceding claims, the allocation (235) being carried out in such a manner that the maximum component variance of all fitting lines (110) is minimized as far as possible (220).

5. Method (200) according to one of the preceding claims, the allocation (235) being carried out in such a manner that the maximum track consumption of all fitting lines (110) is minimized as far as possible (220).

6. Method (200) according to one of the preceding claims, the allocation (235) being carried out in such a manner that the sum of component variances of all fitting lines (110) is minimized as far as possible (220).

7. Method (200) according to one of the preceding claims, the allocation (235) being carried out in such a manner that the sum of track consumptions of all components (155) of a fitting line (110) is below a predetermined threshold (225).

8. Method (200) according to one of the preceding claims, the allocation (235) being carried out in such a manner that the sum of track consumptions of all components of a fitting line (110) is above a predetermined threshold (230).

9. Method (200) according to one of the preceding claims, the allocation (235) being carried out in such a manner that the sum of track consumptions of all components (155) of a fitting line (110) is minimized as far as possible (220).

10. Method (200) according to one of the preceding claims, the allocation (235) being carried out in such a manner that a criterion comprising a plurality of weighted individual criteria is optimized as far as possible.

11. Control device (115) for allocating printed circuit boards (120) to fitting lines (110) of a fitting system (100), the control device (115) being set up:

- to detect requirements for fitting a plurality of printed circuit boards (120) with components (155) to be respectively fitted thereon;
- a requirement defining a printed circuit board (120) and the components (155) to be fitted thereon;
- to allocate (235) the printed circuit boards (120) to fitting lines under given specifications by means of integer linear programming in such a manner that component variances of the fitting lines (110) are as similar as possible,
- the component variance of a fitting line (110) representing the number of different components (155) which can be fitted on all printed circuit boards (120) allocated to the fitting line (110).

**Revendications**

1. Procédé (200) pour équiper des cartes de circuits imprimés (120) au moyen de lignes de montage (110) d'un système de montage (100) pour équiper des cartes de circuits imprimés (120) de composants électroniques (155), le procédé (200) comprenant les étapes suivantes :

- détection (205) de requêtes d'équipement de plusieurs cartes de circuits imprimés (120) avec des composants (155) à monter respectivement dessus,
- une requête définissant une carte de circuits imprimés (120) et les composants (155) à monter dessus, et
- affectation (235) des cartes de circuits imprimés (120) à des lignes de montage (110) dans des conditions prédéfinies au moyen d'une programmation linéaire entière et
- équipement des cartes de circuits imprimés (120) sur les lignes de montage (110) respectivement affectées, **caractérisé en ce que**
- l'affectation (235) est opérée de manière telle que des variations des composants des lignes de montage (110) sont identiques dans la mesure du possible,
- la variation des composants d'une ligne de montage (110) représentant le nombre de composants différents (155) à monter sur toutes les cartes de circuits imprimés (120) affectées à la ligne de montage (110).

2. Procédé (200) selon la revendication 1, l'affectation (235) étant opérée de manière telle que la variation des composants de chaque ligne de montage (110) se situe en dessous d'un seuil prédéfini (210).

3. Procédé (200) selon la revendication 1 ou 2, l'affectation (235) étant opérée de manière telle que la variation des composants de chaque ligne de montage (110) se situe au-dessus d'un seuil prédéfini (215).

4. Procédé (200) selon l'une des revendications précédentes, l'affectation (235) étant opérée de manière telle que la variation maximale des composants de toutes les lignes de montage (110) est minimisée autant que possible (220).

5. Procédé (200) selon l'une des revendications précédentes, l'affectation (235) étant opérée de manière telle que la consommation maximale des pistes de toutes les lignes de montage (110) est minimisée autant que possible (220).

6. Procédé (200) selon l'une des revendications précédentes, l'affectation (235) étant opérée de manière telle que la somme des variations des composants de toutes les lignes de montage (110) est minimisée autant que possible (220).

7. Procédé (200) selon l'une des revendications précédentes, l'affectation (235) étant opérée de manière telle que la somme des consommations de pistes de tous les composants (155) d'une ligne de montage (110) se situe en dessous d'un seuil prédéfini (225).

8. Procédé (200) selon l'une des revendications précédentes, l'affectation (235) étant opérée de manière telle que la somme des consommations de pistes de tous les composants d'une ligne de montage (110) se situe au-dessus d'un seuil prédéfini (230).

9. Procédé (200) selon l'une des revendications précédentes, l'affectation (235) étant opérée de manière telle que la somme des consommations de pistes de tous les composants (155) d'une ligne de montage (110) est minimisée (220) autant que possible.

10. Procédé (200) selon l'une des revendications précédentes, l'affectation (235) étant opérée de manière telle qu'est optimisé, autant que possible, un critère qui inclut plusieurs critères individuels pondérés.

11. Dispositif de commande (115) pour affecter des cartes de circuits imprimés (120) à des lignes de montage (110) d'un système de montage (100), le dispositif de commande (115) étant aménagé pour :

   - détecter des requêtes d'équipement de plusieurs cartes de circuits imprimés (120) avec des composants (155) à monter respectivement dessus,
   - une requête définissant une carte de circuits imprimés (120) et les composants (155) à monter dessus ;
   - affecter (235) les cartes de circuits imprimés (120) dans des conditions prédéfinies au moyen d'une programmation linéaire entière de manière telle à des lignes de montage que des variations des composants des lignes de montage (110) sont identiques dans la mesure du possible,
   - la variation des composants d'une ligne de montage (110) représentant le nombre de composants différents (155) qui doivent être montés sur toutes les cartes de circuits imprimés (120) affectées à la ligne de montage (110).

# FIG 1

FIG 2

200

205

210

215

220

225

230

235

FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009013353 B3

- EP 0478361 A1

**In der Beschreibung aufgeführte Nicht-Patentliteratur**

- **HANS-OTTO GÜNTHER et al.** Workload planning in small lot printed circuit board assembly. *OR Spectrum,* 01. Juni 1997, vol. 19 (2), 147-157

- **DINO LUZZATTO et al.** Cell formation in PCB assembly based on production quantitative data. *European Journal of Operational Research,* 01. September 1993, vol. 69 (3), 312-329
- **SZE MAN TING.** *Component Grouping for Circuit Board Assembly,* 01. Januar 1999